# EUROPEAN PATENT SPECIFICATION

(11) **EP 4 445 302 B1**
(45) Date of publication and mention of the grant of the patent: **23.09.2026**
(21) Application number: 22942929.5
(22) Date of filing: 08.12.2022
(51) Int. Cl.: G06N 10/40, B82Y 10/00, G06N 10/20

(54) **CONTROLLABLE TOPOLOGICAL QUBIT ENTANGLEMENT**
STEUERBARE TOPOLOGISCHE QUBIT-VERSCHRÄNKUNG
ENCHEVÊTREMENT DE BITS QUANTIQUES TOPOLOGIQUES POUVANT ÊTRE COMMANDÉS

(30) Priority: 08.12.2021 US 202163287518 P
(43) Date of publication of application: 16.10.2024
(73) Proprietor: Quoherent Inc., Huntsville, AL 35805 (US); Reich, Alton, J., Huntsville, AL 35805 (US); Carroll, David, L., Winston-salem, NC 21104 (US); Di Salvo, Roberto, Cincinnati, OH 45245 (US)
(72) Inventor: REICH, Alton, J., Huntsville, AL 35805 (US); CARROLL, David, L., Winston-salem, NC 21104 (US); DI SALVO, Roberto, Cincinnati, OH 45245 (US)
(74) Representative: Invent Horizon IP
(86) International application number: PCT/US2022/052267
(87) International publication number: WO 2023/224659

(56) References cited:
- WO-A1-2020/168097
- WO-A1-2020/249630
- WO-A1-2021/158269
- CN-A- 105 470 116
- US-A1- 2019 228 331
- US-A1- 2020 194 566
- US-B2- 7 605 600
- US-B2- 8 912 821
- YUN-PIL SHIM ET AL: "Controllable anisotropic exchange coupling between spin qubits in quantum dots", ARXIV.ORG, CORNELL UNIVERSITY LIBRARY, 201 OLIN LIBRARY CORNELL UNIVERSITY ITHACA, NY 14853, 2 December 2010 (2010-12-02), XP080466110, DOI: 10.1103/PHYSREVLETT.106.180503
- OHNO H ET AL: "Electric-field control of ferromagnetism", NATURE,, vol. 408, no. 6815, 21 December 2000 (2000-12-21), pages 944 - 946, XP002502265
- DIVINCENZO D P ET AL: "Universal Quantum Computation with the Exchange Interaction", ARXIV.ORG, CORNELL UNIVERSITY LIBRARY, 201 OLIN LIBRARY CORNELL UNIVERSITY ITHACA, NY 14853, 26 May 2000 (2000-05-26), XP080020567, DOI: 10.1038/35042541
- THORN STEPHANIE L., SHUMAN JAMES A., STACY MITCHEL R., PURCELL BRENDAN P., DOVIAK HEATHER, BURDICK JASON A., SPINALE FRANCIS G., S: "Matrix Metalloproteinase-Targeted SPECT/CT Imaging for Evaluation of Therapeutic Hydrogels for the Early Modulation of Post-Infarct Myocardial Remodeling", JOURNAL OF CARDIOVASCULAR TRANSLATIONAL RESEARCH, SPRINGER US, BOSTON, vol. 16, no. 1, 1 February 2023 (2023-02-01), Boston , pages 155 - 165, XP093138153, ISSN: 1937-5387, DOI: 10.1007/s12265-022-10280-7

## Description

### BACKGROUND OF THE INVENTION:

### Field of the Invention

The field of this invention relates to quantum logic gates and other quantum registers comprising topological qubits and selectively entangling qubits.

### Description of Related Art

One limitation of quantum computers is that the connectivity of qubits is static so that the interconnectivity of the qubits cannot be changed. This limits which qubits in a qubit array can be entangled with one another. A quantum computing circuit, for example, cannot easily be reconfigured to change the arrangement of qubits to form different combinations of entangleable qubits. The ability to selectively reconfigure the pattern of entanglement between qubits in an array would also allow one or more qubits to be isolated from the rest of the qubit array, for example to remove an improperly functioning qubit or to divide the qubit array into multiple independently functioning qubit arrays. The ability to temporarily isolate qubits would also allow the functionality of individual qubits to be tested.

PCT/US20/56725 describes a qubit device comprising a semiconductor nanocrystal immobilized on a substrate and in contact with electrodes. The crystal exhibits a charge pair symmetry and with an electron spin current on its edges. The qubit can be placed in a state of superposition wherein the direction of the spin current is unknown until measured. The direction of the spin current, once measured, can be used to produce a binary output corresponding to a logical zero or a logical one. A state of the qubit device is monitored by measuring a voltage, a current, or a magnetic field and assigning a superposition or base state depending on a threshold value. PCT/US22/47295 describes quantum computing hardware comprising topological qubits comprising topological quantum nanoparticles that exhibit stable superpositions of electron spin current that can be entangled at non-cryogenic temperatures. The topological quantum nanoparticles are chiral topological insulator nanoparticles that can have a stable superposition of spin current electron flows around the TQN as well either of two states in which the spin electron currents flow in different directions around the TQN. The TQN may be placed on a substrate to make topological quantum registers and topological quantum logic gates. Electrical connections between the topological qubits may comprise switches, which allow topological qubits in an array to be reconfigured. PCT/US22/47295 does not describe entanglement through magnetic connections in which the magnetic connections that can be controlled to entangle or disentangle magnetically connected qubits or controlling a magnitude or scale of entanglement. YUN-PIL SHIM ET AL: "Controllable anisotropic exchange coupling between spin qubits in quantum dots", 2 December 2010, discloses a method for controlling anisotropic interactions between spins arranged in a bus geometry. The symmetry is broken by an external magnetic field, resulting in XXZ-type interactions that can generate entangled Greenberger-Horne-Zeilinger (GHZ) states or universal gate sets for exchange-only quantum computing. OHNO H ET AL: "Electric-field control of ferromagnetism", 21 December 2000, discloses electric-field control of ferromagnetism in a thin-film semiconducting alloy, using an insulating-gate field-effect transistor structure. WO2020/249630A1 discloses a method and a device (100) for providing anyons that may be used for topological quantum computation.

### BRIEF SUMMARY OF THE INVENTION:

Embodiments of the present invention seek to mitigate, alleviate or eliminate one or more of the challenges, such as the above identified.

The invention is set forth in the independent claims and further embodiments are defined in the dependent claims.

### BRIEF DESCRIPTION OF THE DRAWINGS:

The elements of the drawings are not necessarily to scale relative to each other, with emphasis placed instead upon clearly illustrating the principles of the disclosure. Like reference numerals designate corresponding parts throughout the several views of the drawings in which:
**Fig. 1** is a top view transmission electron micrograph of a bipyramidal pnictogen trichalcogenide, PTC nanoplatelet;
**Fig. 2** is an illustration of the process of bipyramidal PTC nanoplatelet growth;
**Fig. 3** is a top view of a pyramidal PTC nanoplatelet;
**Fig. 4** is a side cross-sectional view of a topological qubit comprising a TQN on a silicon substrate;
**Fig. 5** is a side cross-sectional view of a topological qubit comprising a TQN on a silicon substrate;
**Fig. 6** is a top view of a topological qubit comprising a TQN on a silicon substrate;
**Fig. 7** is an example of a current measurement result;
**Fig. 8** is a top view of a topological qubit configured for capacitance measurement;
**Fig. 9** is a top view of an alternate topological qubit configured for capacitance measurement;
**Fig. 10** **is** a top view of an alternate topological qubit configuration for capacitance measurement;
**Fig. 11** is an example of a capacitance measurement result;
**Fig. 12** is a top view of an alternate topological qubit configuration for magnetic measurement;
**Fig. 13** is a side view illustrating proximity entanglement between TQNs in a topological qubit register;
**Fig. 14** is a side cross-section view illustrating top to top electrical entanglement;
**Fig. 15** is a side cross-section view illustrating top to bottom electrical entanglement;
**Fig. 16** is a side cross-section view illustrating bottom to bottom electrical entanglement;
**Fig. 17** is a top view illustration of a six topological qubit register of proximity entangled TQNs;
**Fig. 18** is a top view illustration of a four topological qubit register of electrically entangled TQNs;
**Fig. 19** is a top view illustration of a two topological qubit register of electrically entangled TQNs configured for capacitance measurement;
**Fig. 20** is a top view illustration of one embodiment of a topological qubit register comprising six qubits and seven switches for selectively entangling topological qubits;
**Fig. 21** is a top view illustration of one embodiment of a topological qubit register comprising eight qubits and fourteen electrical connections with switches for selectively entangling topological qubits;
**Fig. 22** is a schematic showing one embodiment of a method for making a topological qubit register;
**Fig. 23** is a photograph of a four topological qubit register;
**Fig. 24** is a schematic representation of a topological quantum computer comprising TQNs;
**Fig. 25** is a diagram illustrating entanglement between two topological quantum nanoplatelets using a magnetic connector;
**Fig. 26** is a cross-sectional, end view of a controllable magnetic connection element.
**Fig. 27** is a diagram illustrating a controllable conditional connection element comprising a magnetic connector and a coil; and
**Fig. 28** is a diagram illustrating one embodiment of a topological quantum register combining different embodiments of controllable conditional entanglement elements.

### DETAILED DESCRIPTION OF THE INVENTION:

Specific embodiments of the invention are described with reference to the accompanying drawings.

All art specific terms are intended to have their art accepted meaning unless otherwise specified. All non-art specific words are intended to have their plain language meanings in the context with which they are used, unless otherwise specified.

As used herein, a nanoparticle is a particle having at least one dimension that is less than 1,000 nanometers, or 1 micrometer, in length. The term "nanoplatelet" is used herein to refer to a nanoparticle having a diameter of from about 1 micrometer to about 20 micrometers and a height of less than about 200 nanometers.

As used herein, a "topological quantum nanoparticle" is a nanoparticle comprising a quantum object that uses its topology to create at least two degenerate charge parity protected quantum states and separates the occupation of the states by reducing tunneling/hopping transitions between the states.

As used herein, a "topological quantum nanocrystal" is a crystalline nanoparticle comprising a quantum object that uses its topology to create at least two degenerate charge parity protected quantum states and separates the occupation of the states by reducing tunneling/hopping transitions between the states. Examples of a "topological quantum nanocrystal" include chiral, self-assembled, bipyramidal pnictogen trichalcogenide, PTC, nanoplatelets and transition metal dichalcogenide, TMD, nanoplatelets comprising Sb₂Te₃, Bi₂Te₃, or MoS₂, optionally decorated with nanoparticles of elements from Group IVA-VIIIA and Group IB of the periodic table of elements and especially nickel, silver, gold, platinum, and/or copper. Examples of other topological insulators include BiₓSb₁₋ₓ, Bi₂Se₃, Bi₂Te₂Se, Bi₄Br₄, beta-Ag₂Te, GeBi₂Te₄, and WC.

Examples of non-crystalline topological quantum nanoparticles include topological insulators having washer, bipyramidal, biconic, or bispiral conic shapes that exhibit a chiral spin current flow.

As used herein, an "electrical connection" to a qubit may be a direct contact via a conducting lead or an indirect connection via a conducting lead positioned in close proximity to the qubit such that a functional electromagnetic connection is formed in which a current or a potential can be conducted between the qubit and the conducting lead. Examples of non-contacting connections include capacitive and inductive connections.

As used herein, a "magnetic connection" between qubits is a physical connection that carries spin-polarised electrons between the qubits. The spin polarization of the electrons may be maintained or reversed by the magnetic connection.

As used herein, "controlling a magnetic connection" means changing the strength of the magnetic connection between qubits connected by the magnetic connector or switching the magnetic connection on and off to allow or interrupt the magnetic connection between qubits.

### Topological Quantum Nanoparticles:

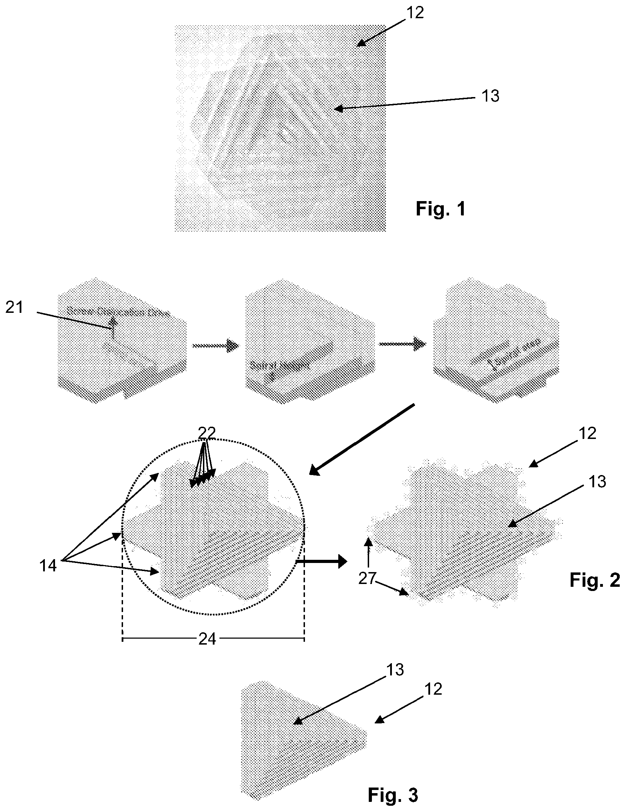

Topological quantum nanoparticles, TQNs, (11) may have different three-dimensional shapes and topologies. One type of TQN (11) comprises a pnictogen trichalcogenide, PTC, having a bipyramidal shape. **Fig. 1** is a top view electron micrograph of a chiral, self-assembled, topological Sb₂Te₃ PTC nanoplatelet (12) in which a triangular spiral structure is visible on the top face (13) of the PTC nanoplatelet (12). Edges (14) of the bottom face (15) are visible around the edges (15) of the top face (13).

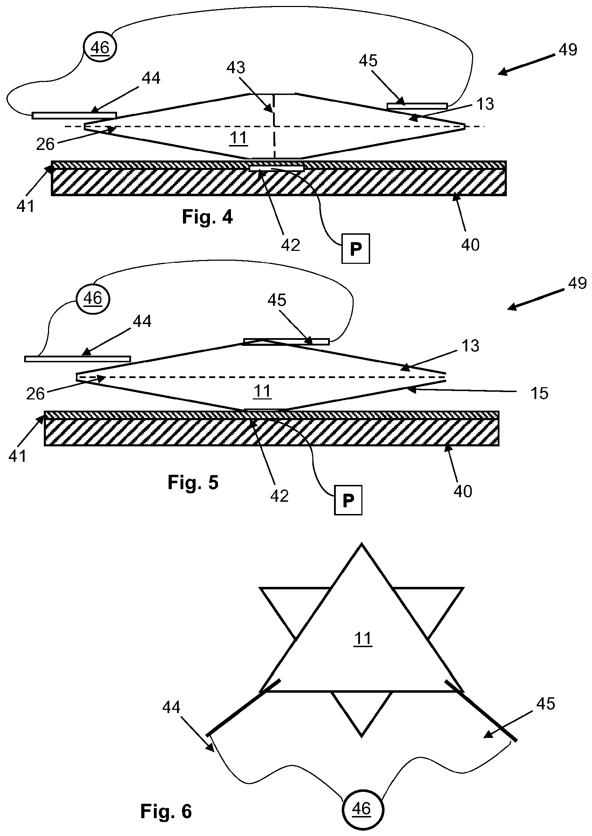

**Fig. 2** illustrates sequential formation of a PTC nanoplatelet (12) of the type shown in **Fig. 1****.** A crystal lattice forms around a central axis (arrow, 21) **(****Fig. 2****)** with sequential layers (22) growing in opposite directions. The diameter (24), or maximum width of the nanoplatelet, is normally at least five times greater than the height of the nanoplatelet in the direction along the central axis of the spirals. Axially, at or near the center of the PTC nanoplatelet (12), a habit plane (26) **(****Fig. 4****)** separates the top and bottom halves of the PTC nanoplatelet (12). A persistent spin current runs along the spiral of the top face (13) from the habit plane (26) to the top and back along the central dislocation (43) **(****Fig. 4****).** This spin current does not cross the habit plane (26) onto the bottom face (15) and a mirror spin current is present in the other half, or bottom face. One spin current direction dominates for any given measurement, so that any measurement of spin current along the outside edges (14) will give a clockwise or counterclockwise current following the spiral. The spin current can be enhanced by doping, or decorating, the habit plane edges (14) with metal nanoparticles (27) as shown in **Fig. 2****.** Additionally or alternatively, the energy difference between bistable points may be adjusted with doping by filling the topological states with an abundance of one type of electron carrier or another to optimize decoherence times at different temperatures.

A PTC nanoplatelet (12) having a pyramidal shape **(****Fig. 3****)** comprises a base plane (31) rather than a habit plane (26) and may be formed by initiation of crystal growth on a substrate by placing a solution capable of forming PTC nanoplatelets (12) onto the substrate and selectively heating spots on the substrate to initiate crystallization. PTC nanoplatelets (12) and other types of TQNs (11) may be formed on a substrate by electrodeposition techniques. Pyramidally shaped PTC nanoplatelets (12) grown on a solid substrate rather than in solution exhibit spin current flow moving either up away from, or down toward, the base plane. As with the bipyramidal shaped nanoplatelets, a central dislocation allows the circuit of current to be complete by allowing the spin current to move either down toward, or up and away from, the base plane. Other examples of TQN shapes include mobius strips and other non-orientable surfaces made of topological insulators.

### Topological Quantum Nanoparticle Production:

Antimony chloride (1.4 g) and tellurium oxide (1.44 g) are combined in 70 ml ethylene glycol under vacuum and mixed until a white solution forms. Sodium hydroxide (1.46 g) is added to the solution and dissolved. 0.8 g PVP is mixed into the solution and the solution is purged with argon gas. The solution is heated to between 125 and 135 ºC, 8 ml hydrazine is added dropwise, the reaction proceeds 2-4 hours, the temperature is raised to 160 ºC and maintained for 12-18 hours, and then allowed to cool to 40 ºC. Precipitate is isolated by centrifugation and washing with acetone and ethanol and resuspended in ethanol with sonication before filtration over 0.1 micron filter.

Bismuth Nitrate Pentahydrate (6 mmol) and Sodium Tellurite (9 mmol) are combined in 70 ml ethylene glycol under vacuum and mixed until a white solution forms. Sodium hydroxide (1.46 g) is added to the solution and dissolved. 0.8 g PVP is mixed into the solution and the solution is purged with argon gas. The solution is heated to 180 ºC for 12-18 hours, and then allowed to cool to 40 ºC. Precipitate is isolated by centrifugation and washing with acetone and ethanol and resuspended in ethanol with sonication before filtration on 0.1 micron filter.

Bismuth Telluride or Antimony Telluride quantum nanoparticles are suspended in 20 mL ethylene glycol and vortexed for 10-20 seconds and sonicated for 5-10 minutes. The resulting suspension is exposed to vaccum and stirred while head space is filled with argon gas. 0.4 g Silver Nitrate is added with mixing at room temperature and the reaction is allowed to proceed for 1 to 15 hours. The resulting solution is transferred to a centrifuge tube and 50 ml acetone is added before centrifugation at 5,000 RPM for 15 minutes. The liquid is decanted and the precipitate is washed in ethanol by vortexing, sonication, centrifufation, and decaninting the liquid. The washed precipitate is resuspended in 20 ml ethaol and 40 ml water and filtered on a 0.1 micrometer filter.

Bismuth Telluride or Antimony Telluride quantum nanoparticles are suspended in 20 mL ethylene glycol and vortexed for 10-20 seconds and sonicated for 5-10 minutes. The resulting suspension is exposed to vaccum and stirred while head space is filled with argon gas. 0.4 g Copper Chloride is added with mixing at 70 ºC and the reaction is allowed to proceed for 1 to 15 hours. The resulting solution is transferred to a centrifuge tube and 50 ml acetone is added before centriguation at 5,000 RPM for 15 minutes. The liquid is decanted and the precipitate is washed in ethanol by vortexing, sonication, centrifugation, and decaninting the liquid. The washed precipitate is resuspended in 20 ml ethaol and 40 ml water and filtered on a 0.1 micrometer filter.

Bismuth Telluride or Antimony Telluride quantum nanoparticles are suspended in 20 mL ethylene glycol and vortexed for 10-20 seconds and sonicated for 5-10 minutes. The resulting suspension is exposed to vaccum and stirred while head space is filled with argon gas. 0.4 g mmol Iron Chloride is added with mixing and the reaction is allowed to proceed for 1 to 15 hours. The resulting solution is transferred to a centrifuge tube and 50 ml acetone is added before centrifugation at 5,000 RPM for 15 minutes. The liquid is decanted and the precipitate is washed in ethanol by vortexing, sonication, centrifugation, and decaninting the liquid. The washed precipitate is resuspended in 20 ml ethaol and 40 ml water and filtered on a 0.1 micrometer filter.

Bismuth Telluride or Antimony Telluride quantum nanoparticles are suspended in 20 mL ethylene glycol and vortexed for 10-20 seconds and sonicated for 5-10 minutes. The resulting suspension is exposed to vaccum and stirred while head space is filled with argon gas. 0.4 g mmol Nickel Chloride is added with mixing and the reaction is allowed to proceed for 1 to 15 hours. The resulting solution is transferred to a centrifuge tube and 50 ml acetone is added before centriguation at 5,000 RPM for 15 minutes. The liquid is decanted and the precipitate is washed in ethanol by vortexing, sonication, centrifufation, and decaninting the liquid. The washed precipitate is resuspended in 20 ml ethaol and 40 ml water and filtered on a 0.1 micrometer filter.

### Topological Quantum Nanoparticle Qubit and Qubit Registers:

**Fig.** 4 is a side cross-sectional view of components of one embodiment of a TQN-based topological qubit (49). The TQN (11), in this case a PTC nanoplatelet (12), is oriented on a silicon wafer substrate (40) having such a surface electrically insulating layer (41) having a thickness of at least 3Å to 7Å so that the habit plane (26) is mainly parallel the insulating layer (41). Examples of suitable electrical insulators include silicon dioxide, sapphire, and alumina. The TQN (11) may be, for example, an Sb₂Te₃ or a Bi₂Te₃ PTC nanoplatelet doped with copper or silver and having a diameter of from about 1 mm to about 20 mm and with a height of less than about 200 nm. The TQN (11) is positioned above a back gate, or bottom gate, lead (42) electrically connected to a power source (P), which can be used to pulse the TQN (11) with an electrical potential of between 0.2 V and 1.0 V for a period of 0.1 msec to 1 msec as a means for placing the TQN (11) into a state of superposition in which the spin current direction around the edge (14) of the habit plane (26) may be considered to be both clockwise and counterclockwise. The back gate lead (42) may physically contact the bottom face (15) of the TQN (11) or be close enough to to transmit a current and potential across a small gap or thin section of silicon dioxide between the lead (42) and the TQN (11).

**Fig.** 4 shows an embodiment in which the back gate lead (42) is not in direct contact with the bottom face (15) of the TQN (11). The back gate lead (42) may be positioned as shown or in direct contact with the bottom face (15) of the TQN (11). A first top lead (44) is in contact with, or in close proximity to, the top face (13) of the TQN (11) near the edge (14) of the habit plane (26). In this example, a second top lead (45) is in contact with, or in close proximity to, the top face (13) of the TQN (11) at a location that is on an opposite side of the top face (13) from the first top lead (44). The second top lead (45) need not be positioned on the opposite side of the top face (13) from the first top lead (44) and may be positioned at a distance from the first top lead (44) sufficient for a current or voltage to be detected between the two leads (44,45), such as at an angle of 120° with respect to the top end (23) of the TQN (11) (Fig. 6). The measured potential difference between the first and second leads (44,45) indicates the direction and magnitude of the spin current. One of the top leads (44,45) may also serve as a ground lead or an additional top lead (not shown) may be used as a ground lead when pulsing the TQN (11) with a potential from the back gate lead (42). The direction of the pulse may be reversed with the back gate lead (42) acting as a ground.

While positioning the back gate lead (42) in or on the substrate (40) is convenient for making the topological qubit (49), the back gate lead (42) is not strictly necessary. The TQN (11) may be pulsed by an additional top gate lead (not shown) in contact with or in close proximity to the top end of the TQN (11) or a lead in contact with or in close proximity to the top face (13) or bottom face (15) of the TQN with a lead with a lead on an opposite side of the TQN (11) acting as a ground.

**Fig. 5** is a side cross-sectional view showing a layout of components of another embodiment of a TQN-based topological qubit (49). In this embodiment, the TQN (11) is oriented as in **Fig. 4****.** The back gate lead (42) in this embodiment is shown as in physical contact with the bottom face (15) of the TQN (11) but the back gate lead (42) may alternatively be close enough to transmit a current and potential across a small gap or thin section of silicon dioxide between the lead and the TQN (11). A first top lead (44) is in contact with, or in close proximity to, the top face (13) of the TQN (11) near the edge (14) of the habit plane (26). In this example, a second top lead (45) is in contact with the top end (23), or in close proximity to, the top end (23) of the TQN (11). The measured potential difference between the first and second leads (44,45) indicates the direction and magnitude of the spin current.

The state measuring means (46) may be based on voltage measuring means, current measuring means, capacitance measuring means, and magnetic field measuring means. One advantage of topological qubits (49) over other quantum computing technologies is a longer coherence time, or the length of time that a qubit can maintain a state of superposition. Coherence measurements of individual topological qubits (49) comprising PTC nanoplatelets (12) indicate that topological qubits have coherence time of from 10 ms to at least 10 s. These coherence times allow ample time for the quantum states of topological qubits (49) to be determined simultaneously after they have been placed into a quantum state of superposition.

### Voltage Measuring Means for Qubit State:

Referring to **Fig. 4****,** the first lead (44) and the second lead (45) are electrically connected to the TQN (11) on the same side of the habit plane (26), which may be the top face (13) as shown, but may alternatively be the bottom face (15). The first and second leads (44,45) are positioned such that they are separated on the nanoplatelet by at least a quarter of the diameter (24) of the TQN (11) and are connected to a means for measuring voltage. The measured potential difference between the first and second leads (44,45) indicates the direction and magnitude of the spin current. For PTC nanoplatelet topological qubits (49), the measured voltage is on the order of microvolts, which is readily measured using existing volt meters. The voltage measurement may be a direct measurement of the potential between the first and second leads (44,45). Alternatively, an alternating potential may be applied a to the leads and a change in phase of the applied potential may be used to detect the direction of current in the qubit (49). For the embodiment shown in **Fig. 5****,** as with the embodiment shown in **Fig. 4****,** the measured potential difference between the first and second leads (44,45) indicates the direction and magnitude of the spin current flowing on the TQN (11).

### Current Measuring Means for Qubit State:

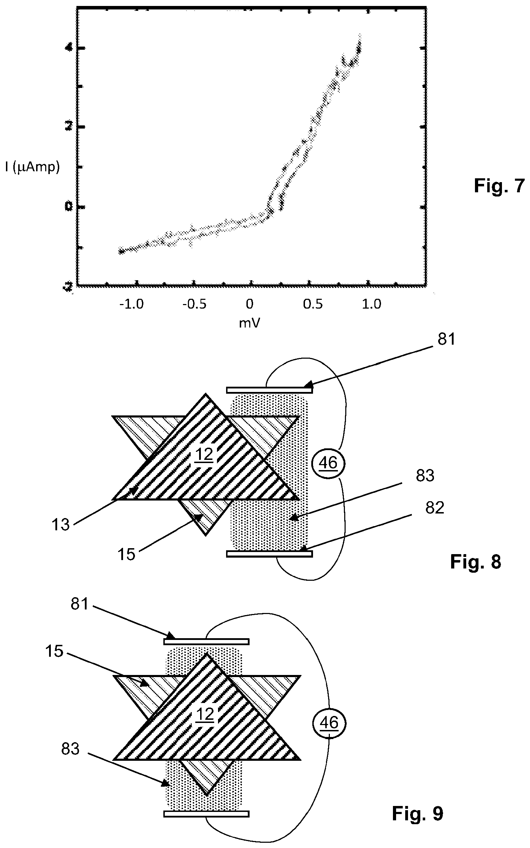

Referring to **Fig. 4****,** the first lead (44) and the second lead (45) are electrically connected to the PTC nanoplatelet (12) on the same side of the habit plane (26), which may be the top face (13) as shown, but may alternatively be the bottom face (15), in which case the leads are bottom face leads. The first and second leads top face (44,45) are positioned such that they are separated on the nanoplatelet by at least half of the diameter (24) of the nanoplatelet (12) and are connected to a means for measuring current such as a complementary metal-oxide-semiconductor (CMOS). The current measured between the first and second top face leads (44,45) indicates the direction and magnitude of the spin current flowing of the PTC nanoplatelet (12). The current may be measured directly or a very low input alternating current on the order of nano amps and millivolts may be delivered through the first top face lead (44) with the current coming from the second top face lead (45) measured. A change in slope for amperage vs. voltage is used to detect the direction of current in the topological qubit (49). **Fig. 7** illustrates an amperage vs. voltage graph in which the states associated with two different spin current directions is distinguished by the differences between the two curves, one for spin current in the opposite direction of the delivered current (left) and one for spin current in the same direction as the delivered current.

The minimum current required to measure voltage depends on the sensitivity of the measuring device. The presence of silver nanoparticles or other nanoparticle dopants such as gold, platinum, copper, nickel and other Group IVA-VIIIA and Group IB metals may be used to form metallic nanoparticles bonded to the edges of the habit plane of PTC nanoplates and establish a metal semiconductor junction that may be used to increase electron density as needed to provide reliable measurable voltages. For any given topological qubit design, one may make a Hall measurement to determine detectable levels of current using a picoammeter and adjust the presence or absence or type or amount of dopant as needed to achieve detectable levels of current.

### Capacitance Measuring Means for Qubit State:

A first embodiment of a topological qubit (49) comprising capacitance state measuring means (46) is illustrated in **Fig. 8****.** A first end (81) of a capacitor (80) is positioned on the substrate (40) or insulating layer (41) on one lateral side of the bottom face (15) of the PTC nanoplatelet (12). A second, opposite end (82) of the capacitor (80) is positioned on the substrate (40) or insulating layer (41) on the opposite side of the bottom face (15) of the PTC nanoplatelet (12). A time varying voltage is applied into the first end (81) of the capacitor (80) and a time varying voltage is measured out from the second end (82) of the capacitor (80). The electric field caused by the spin electron current of the topological qubit (49) will cause a phase shift between the applied and measured voltages with the magnitude of the phase shift indicating which direction the current is flowing in the PTC nanoplatelet (12). The first and second ends (81,82) of the capacitor (80) are preferably positioned off center with respect to the PTC nanoplatelet (12) as shown in **Fig. 8** but they may alternatively be positioned centrally with respect to the PTC nanoplatelet (12) as shown in **Fig. 9****.** For embodiments as shown in **Figs. 8 and 9****,** the first and second ends (81,82) of the capacitor (80) may be positioned on opposite sides of the top face (13) of the PTC nanoplatelet (12) instead of the bottom face (15) of the PTC nanoplatelet (12).

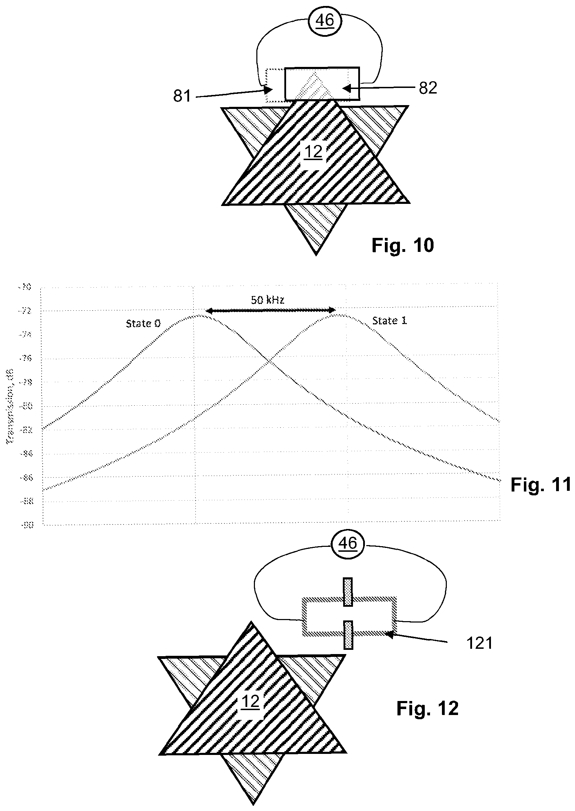

An electrolyte (83) may be placed between the first and second ends (81,82) of the capacitor (80) and in contact with the PTC nanoplatelet (12) so that voltage and current may be measured at the second end (82) of the capacitor (80) **(****Fig. 12****)** with the phase shift of the current and/or voltage identifying the state of the PTC nanoplatelet (12).

Another capacitance measuring configuration for a qubit (49) is illustrated in **Fig. 10****.** A first end (81) of a capacitor (80) is positioned on the substrate (40) or an insulator layer (41) on the substrate below the PTC nanoplatelet (12). An insulator (dielectric) layer is placed on the first end (81) of a capacitor, preferably before the PTC nanoplatelet (12) is placed on the substrate (40). An insulator layer is applied to the top side of the PTC nanoplatelet (12) above the first end (81) of a capacitor. A second end (82) of the capacitor (80) is positioned above the insulator on the top half of the PTC nanoplatelet (12). A time varying voltage is applied into the first end (81) of the capacitor and a time varying voltage is measured out from the second end (82) of the capacitor. The electric field of the qubit will cause a phase shift between the applied and measured voltages with the magnitude of the phase shift indicating which direction the current is flowing in the PTC nanoplatelet (12).

**Fig. 11** illustrates a capacitance measurement output that may be used to determine a state of a PTC -based qubit, depending on the direction of the applied time varying voltage ad the direction of the spin current. If the directions of the applied voltage and spin current are opposite one another, the phase shift will be to the left as for State 0. If the directions of the applied voltage and spin current are aligned with one another, the phase shift will be to the right as for State 1.

A SQUID measuring means for determining the state (46) of the PTC nanoplatelet (12) is illustrated in **Fig. 12****.** The SQUID loop (121) is positioned in close proximity to the PTC nanoplatelet (12) to measure the magnetic field in and near the SQUID loop (121), which indicates the direction of current flow in the PTC nanoplatelet (12). A disadvantage of this means for determining the state (46) of the PTC nanoplatelet (12) is that cryogenic temperatures are required for the measurement, while the qubit is operational at room temperature. Cryogenic temperatures, however, may greatly extend the coherence times of the qubit for certain applications.

### Entanglement of Qubits:

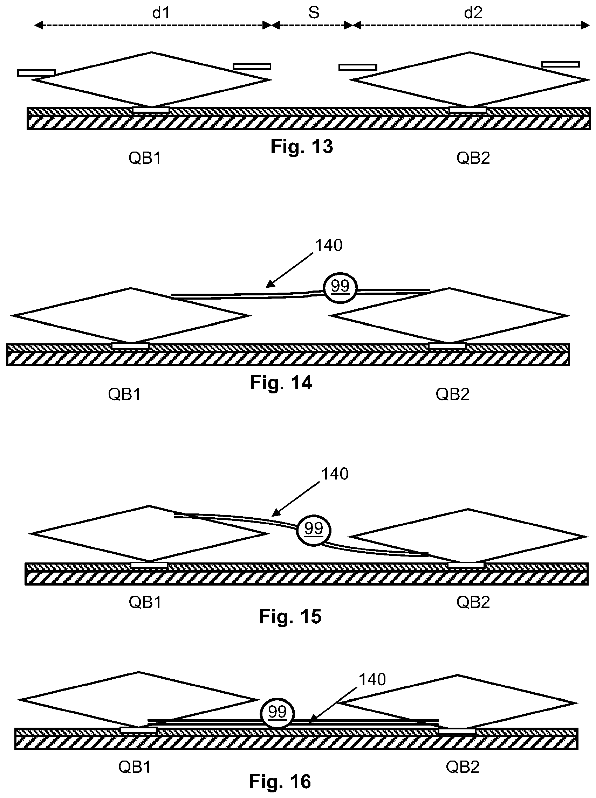

TQN-based qubits can be entangled by proximity, electrical connection, and selectable electrical connection. **Fig. 13** illustrates one example of entangling two topological qubits (49) by proximity. A first PTC -based qubit (QB1) having a diameter (d1) may be entangled with a second qubit (QB2) having a dimeter (d2) with the first and second qubits being separated by a distance S. The distance S is small enough for the electric or magnetic fields associated with the spin currents to influence one another. For an average diameter (AD) of the first and second qubits (d1+d2)/2, S is preferably in a range of from 0.01AD to 1.0AD, or from 0.01 mm to 5.0 mm for AD ranging from 1 mm to 5 mm. The optimal spacing may vary depending on the composition and size of the topological qubits (49). Entangled topological qubits (49) oriented side by side in the same plane have opposite directions of spin current. Topological qubits (49) oriented top to bottom to be vertically entangled by proximity have the same directions of spin current.

TQN-based qubits can also be entangled by electrical connection using connecting leads (140) to electrically connect topological qubits (49) to one another. The interconnecting leads (140) are impedance matched. **Figs. 14-16** are side cross-sectional views of two qubits connected by a lead (140) comprising an optional solid-state switch (99), such as a microtransistor, for selectively entangling or disentangling the two topological qubits (49). The qubits may be electrically connected top to top through a connecting lead (140), bottom to bottom through their back gate leads (42), or top to bottom or bottom to bottom through their back gate leads (42) and/or a connecting lead (140), optionally comprising a transistor or other solid state switch (99).

Connecting PTC nanoplatelet (12) topological qubits (49) top to top **(****Fig. 14****)** or bottom to bottom **(****Fig. 16****)** entangles them to have opposite directions of spin current and connecting qubits top to bottom **(****Fig. 15****)** or bottom to top entangles them to have the same directions of spin current. The connecting leads (140) are shown as being above the substrate (40) and insulating layer (41) but a connecting lead (140) may be on or in the substrate (40) or insulating layer (41) for a portion of all of its length. Back gate electrodes (42) may be connected by a conducting lead in, on, or under the substrate (40).

Solid state switches (99) may be incorporated into the connecting leads (140) to allow topological qubits (49) to be selectively entangled or disconnected. The connecting leads may extend to a location remote from the substrate (40), for example to a conventional computer or microprocessor for controlling the switches (99). It is also possible to arrange an array of qubits with some of the qubits entangled by proximity, some entangled by electrical connection, and some qubits entangled with a plurality of qubits by proximity and/or electrical connections. Solid state switches (99) suitable for use with electrical connecting leads (140), including micro transistors, are commercially available.

### Topological Quantum Nanoparticle Registers:

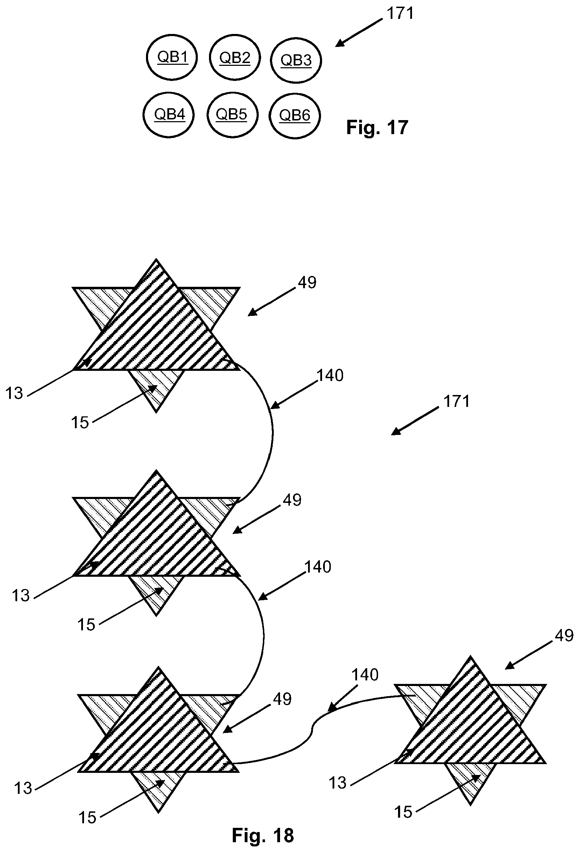

A topological qubit register (171) comprises at least two entangleable topological qubits (49) arranged on a substrate (40) with each qubit electrically connected to a bottom, or back gate (42), comprising an electrical conductor. The back gate (42) may be configured as an discrete structure or it may be an exposed portion of a larger electrode that forms a plurality of back gates (42). **Fig. 17** is a schematic top view of one embodiment of a TQN-based register (171) comprising an array of six topological qubits (49, QB-QB6) entangled by proximity. QB 1 is entangled with QB2 and QB4, QB2 is entangled with QB1, QB3, and QB5. QB3 is entangled with QB2 and QB6. QB4 is entangled with QB1 and QB5. QB5 is entangled with QB2, QB4, and QB6. QB 6 is entangled with QB3 and QB5. Since all of the qubits (49) are arranged side-by-side, their entanglement is such that each topological qubit (49) has an opposite direction of spin current from each neighboring qubit. Specific types of logic gates can be generated by the placement of qubits in different relative spatial positions (e.g. side to side and/or top to bottom) to provide any desired entanglement patterns.

**Fig. 18** is a top view schematic of a TQN-based register (171) comprising a series array of four PTC -based topological qubits (49) electrically entangled top to bottom. The topological qubits (49) are electrically connected in series by conducting leads (140), which may run along the top of the substrate, inside the substrate, below the substrate, and/or combinations of these. In alternative embodiments, any number of topological qubits (49) may all be connected top to top or in any combination of top to top, top to bottom, and bottom to top. Additionally or alternatively, any one of the qubits may be electrically connected to and entangled with more than one of the other qubits. Any number or combination of conducting leads may comprise a solid state switch (99).

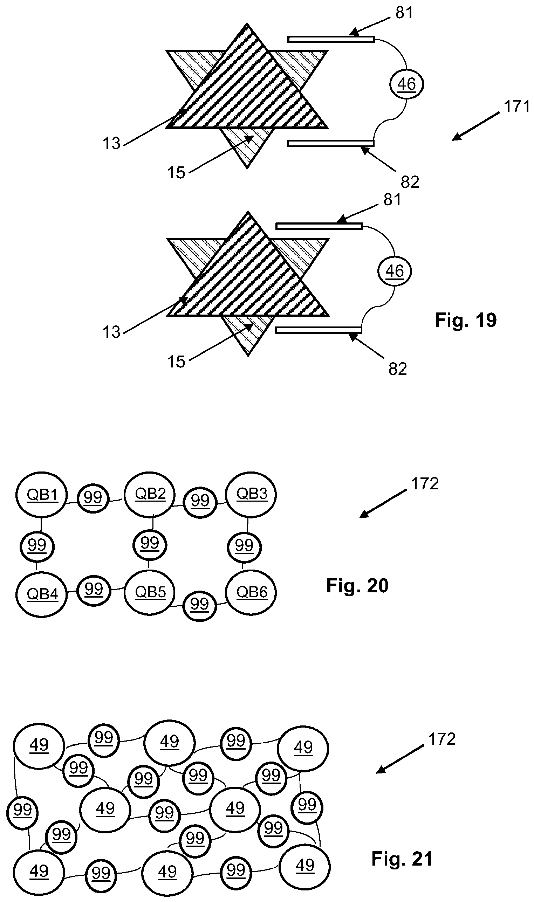

**Fig. 19** is a top view schematic of a register (171) comprising two PTC -based topological qubits (49) and capacitance measuring means (46) to illustrate one example configuration for simultaneously determining the quantum current states of both topological qubits (49). The topological qubits (49) may be connected top to top or top to bottom. Additionally or alternatively, the two qubits may be electrically connected to separate back gate leads or a common back gate lead. Having the qubits electrically connected to a common back gate lead simplifies the process of pulsing both qubits at the same time to set them into superposition states. This applies to arrays of qubits as well as portions of arrays of qubits (49).

**Fig. 20** is a top view schematic of an array (172) comprising six topological qubits (49) entangled with seven selectively switchable connecting leads. QB1 can be selectively entangled with QB2 and/or QB4, QB2 can be selectively entangled with QB1, QB3, and/or QB5. QB3 can be selectively entangled with QB2 and/or QB6. QB4 can be selectively entangled with QB1 and/or QB5. QB5 can be selectively entangled with QB2, QB4, and/or QB6. QB6 can be selectively entangled with QB3 and/or QB5. The switch containing connecting leads (140) may be configured to connect any pair of qubits top to top or top to bottom to allow the configuration of different types of logic gates using the same array of topological qubits (49). Solid state switches (99) may be incorporated into any array of qubits to allow the gating to be reconfigured by opening or closing them to change connection patterns to form differently configured registers and/or gates.

**Fig. 21** is top view schematic of an embodiment of an array of eight topological qubits (49) connected by fourteen connecting leads (140) comprising selectively switchable solid state switches (99). As can be seen in the figures, arrays of topological qubits may have any number of spatial arrangements or configurations, including square, rectangular, triangular, and diamond arrays making it possible to create a wide variety and number of gates and registers using the same array (172). Using switchable more than one switchable connecting lead (140) between pairs of topological qubits (49), or a combination of a switchable connecting lead (140) and a switchable back gate electrode (42), it is possible to change the entanglement between pairs of topological qubits (49) between top to top, top to bottom, bottom to top, and/or bottom to bottom.

### Topological Quantum Circuits:

A topological quantum circuit may be constructed by forming a sequence of topological quantum gates. One advantage of constructing an array (172) of topological qubits (49) connected by connecting leads (140) comprising selectively switchable solid state switches (99) is that the solid state switches may be used to generate different topological quantum circuits from the same array of static topological qubits.

### Topological Quantum Nanoparticle Qubit and Register Production:

A qubit and qubit registers can be made using preformed TQNs using several methods. Qubits may be made by forming a gate electrode on a nonconducting substrate, forming an insulating layer over the gate, anchoring a semiconductor nanoparticle crystal onto the insulating layer in contact with or in apposition to the gate electrode, and placing electrodes on or in apposition to the top half of the crystal.

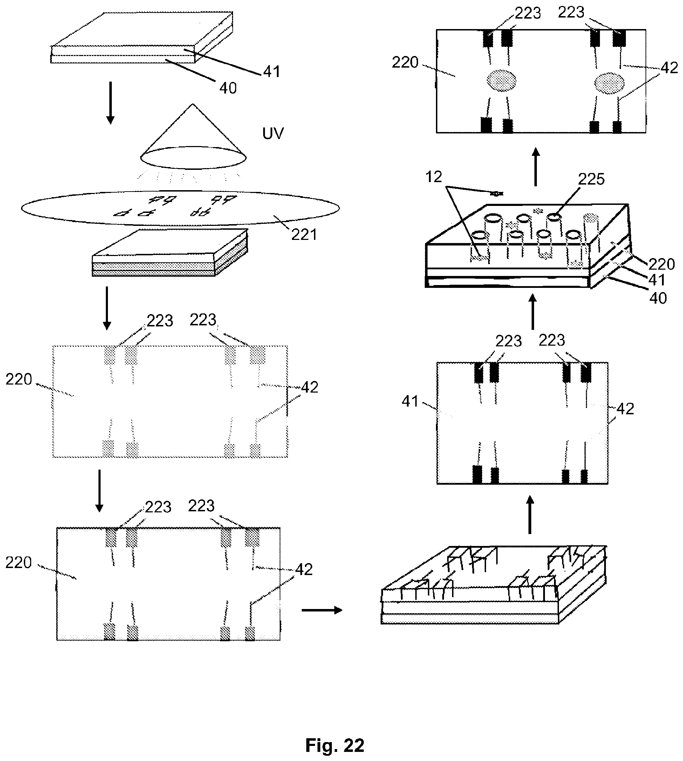

**Fig. 22** is a pictogram illustrating one embodiment of a lithographic method for making a TQN register (171). A substrate (40) comprising a silicon wafer with a surface layer of silicon dioxide insulator (41) is covered with a photoresist (220) and a mask (221) outlining the positions of back gate leads (42) to which PTC nanoplatelets (12) will be electrically connected and the mask is exposed to UV light (UV). The mask (221) is removed and the photoresist (220) is developed to expose silicon (40) where the back gate leads (42) and contacts (223) are desired. Vapor deposition is used to deposit an electrical conductor such as aluminum or gold on the exposed silicon to make the back gate leads (42) and contacts (223) and the remaining photoresist is removed. A new layer of photoresist (220) is applied and covered with a mask having holes where the PTC nanoplatelets (12) are to be positioned over the back gate leads (42). The holes are approximately the diameter of the PTC nanoplatelets to be used (e.g. 2-3 microns). The mask is exposed to UV light and removed. The photoresist is developed to form wells (225) in the photoresist (220) where it was exposed to UV light. A dilute suspension of PTC nanoplatelets (12) is deposited onto the surface of the photoresist and an electrical potential is applied across the substrate and photoresist to cause the PTC nanoplatelets (12) to migrate into the wells above the back gate leads (42). The electric potential may be applied in the form of a matrix or array of spot potentials corresponding to the positions of the wells in the second photoresist. The suspension of PTC nanoplatelets (12) is preferably sieved so that the suspension contains nanoplatelets of a consistent size corresponding to the size of the holes made in the second photoresist. Sieving may be achieved by electrophoresis or size exclusion chromatography, for example. The second photoresist may be removed before connecting leads (140) connecting to the top faces (13) of the PTC nanoplatelets (12) are made using standard e-beam lithography.

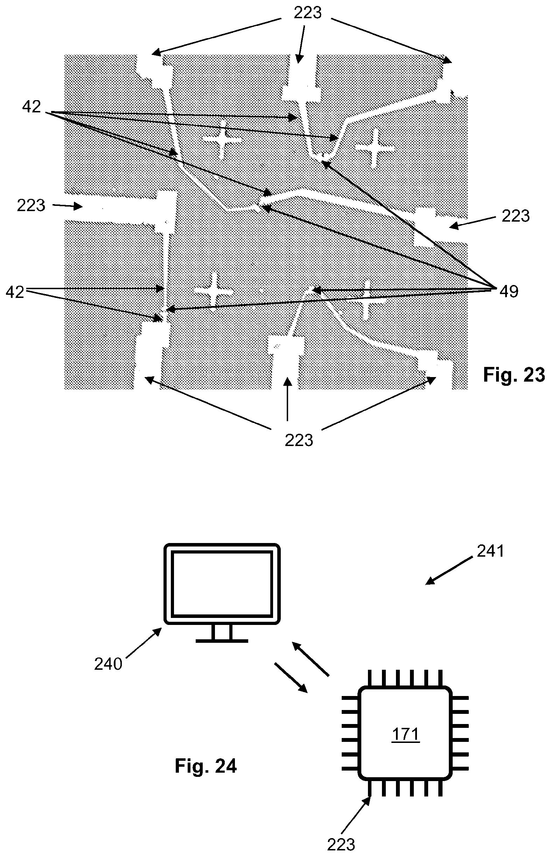

**Fig. 23** is a top view photograph of one embodiment of an array (172) of four topological qubits (49) on a silicon wafer (or chip) substrate with a silicon dioxide insulating layer forming a four-qubit register (171). Contacts (223) and leads (42) were made using standard e-beam lithography such that the leads (42) are electrically connected to the top faces (13) of PTC nanoplatelets (12) that are positioned over back gate electrodes (not visible). The contacts (223) extend a small distance beyond the edge of the photograph and wafer for further electrical connection to a computer comprising software that controls a power supply for setting the qubits into a state of superposition and for simultaneously measuring the quantum states of the four topological qubits (49) simultaneously. For embodiments of a qubit array (172) comprising switchable leads, the computer additionally comprises software for controlling solid state switches. The computer may comprise software configured for testing each individual topological qubit (49) for being functional for being placed into a state of superposition and for entanglement with other qubits as well as isolating nonfunctional qubits from the rest of the qubits in the array.

### Topological Quantum Nanoparticle Computer:

A TQN computer, or topological quantum computer (241) may comprise a classical computing device (240) interfacing with at least one TQB-based register (171). The computing device provides sets of instructions executed by convention circuitry to communicate with, control, and receive information from the quantum register (171). The computing device (240) sets TQN-based topological qubits (49) to desired states, for example by setting a superposition state or a state with one direction of current flow or another by controlling a potential applied to the back gate electrodes (42). The computing device (240) communicates with means for measuring quantum states (46) of the topological qubits (49). The computing means may comprise means for measuring quantum states (46) that are electrically connected to contacts on the topological quantum register (171).

Advantages of TQN-based quantum registers (171) include their ability to operate at temperatures compatible with standard digital computers and that they can be manufactured using methods and materials compatible with those for making digital computers. This means that it is possible integrate one or more TQN-based quantum registers (171) into a conventional digital computer (240) in which the one or more quantum registers (171) is incorporated into the circuitry of the digital computer. It is also possible to construct a universal topological quantum computer comprising a complete set of topological qubit logic gates.

Operation of a topological quantum computer (241) may comprise the following operations:
using the digital computer (240), addressing each topological qubit (49);
using the digital computer (240), performing one or more functional tests to identify which topological qubits (49) are functioning properly and which are not;
using the digital computer (240), receiving input data through a user interface or from a program to determine which interconnections are made between topological qubits by controlling solid state switches;
using the digital computer (240), controlling solid state switches connecting topological qubits to form one or more topological quantum registers (171);
using the digital computer (240), controlling solid state switches connecting topological qubits to form one or more topological quantum gates;
using the digital computer (240), controlling solid state switches connecting topological qubits to form one or more topological quantum circuits;
using the digital computer (240), providing a timing circuit for sequential and simultaneous actions including setting topological qubits into superposition (254) and measuring states of collections of entangled topological qubits; and
using the topological quantum register(s), performing a quantum Fourier transform.

Some or all of the operations may be performed in a variety of sequences and many other operations are possible. Some of the operations are performed iteratively. For example, once the solid state switches have been set under the control of the digital computer, the qubits may be repeatedly set to superposition and measured.

### Controllable Conditional Entanglement Between Topological Qubits:

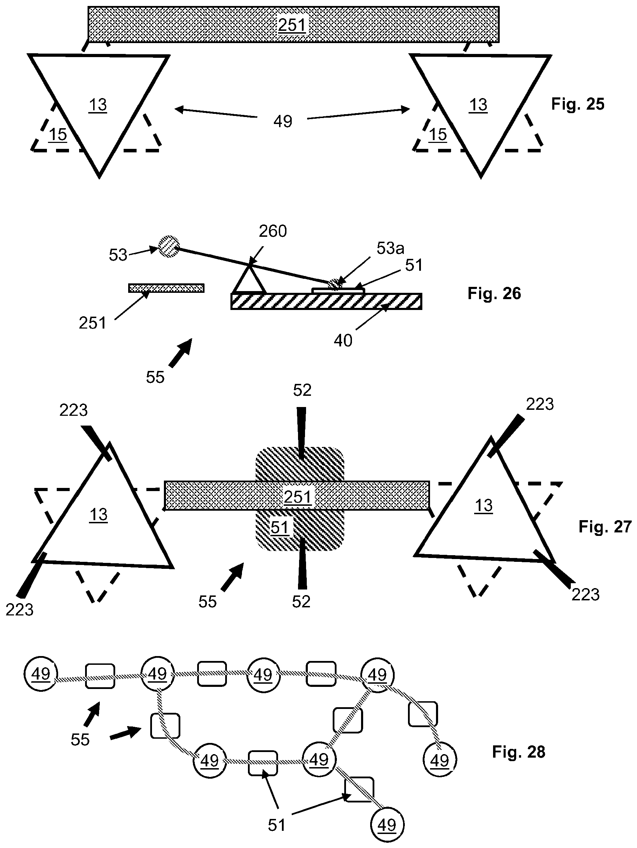

Topological qubits are connected by a magnetic connector (251) comprising a dilute magnetic semiconductor to transmit spin polarised electrons, or spin current, from one topological qubit (49) to another. Examples of dilute magnetic semiconductors include tungsten-doped vanadium selenide (V-doped WSe₂), which may be deposited via masked chemical vapor deposition, and Tungsten-doped Vanadium Oxide (W-doped VO₂), which may be deposited via masked sputtering of Tungsten and Vanadium Oxide. Other examples of dilute magnetic semiconductors include epitaxially grown Ge₁₋ₓMnₓ films and TiO₂, SnO₂, ZnO or In₂O₃ doped with Co, V, Fe or Ni. A magnetic connector (251) comprising lithium-doped graphene reverses spin polarisation between topological qubits (49). **Fig. 25** illustrates an example showing two TQN-based topological qubits (49) connected by a magnetic connector (251) through their bottom faces (15). The magnetic connections between topological qubits (49) may be bottom-to-bottom as in **Fig. 25** or top-to-top, top-to-bottom, or bottom-to-top. One potential advantage of bottom-to-bottom connections is that the magnetic connector (251) may be deposited on the substrate of the qubits.

The ability of the magnetic connector (251) to transmit spin current may be controlled using a magnet to change a magnetic field passing through the magnetic connector (251) to allow or prevent the propagation of spin current. This may be done, for example, by moving a permanent magnet (53) relative to the magnetic connector (251) using a cantilever mechanism. **Fig. 26** is a cross-sectional, end view of a controllable magnetic connection element (55) comprising a magnetic connector (251) and a cantilever (260) holding a primary permanent magnet (53) and a secondary permanent magnet (53a). An electrical coil (51) is activated to produce a magnetic field causing repulsion between the secondary magnet (53a) and the coil (51), which moved the primary permanent magnet closer to the magnetic connector (251) and thereby alters the paramagnetic/diamagnetic character of the magnetic connector (251) and prevents the transmission of spin current. The cantilever (260) and electrical coil (51) are fixed relative to the magnetic connector, preferably on a substrate (40) supporting the cubits.

**Fig. 27** illustrates an example of a controllable magnetic connection element (55) comprising an electromagnet, or electrical coil, (51) in close proximity to the magnetic connector (251) to control the magnetic properties of the magnetic connector. The coil (51) is preferably directly above or directly below the magnetic connector (251) so that passing a current through the coil via coil leads (52) causes the coil (51) to produce an induced magnetic field that alters the paramagnetic/diamagnetic character of the magnetic connector (251). The electrical coil (51) may be energized and de-energized under the control of the digital computer (240) in the same manner as a solid-state switch. The electric leads (223) are shown as providing electrical connection to the top faces (13) of the topological qubits (49) but the connections can be made in accordance with any of the embodiments described for connection to measuring means (46). The configuration shown in the figure may function as a quantum CNOT gate.

A series of controllable magnetic connection elements (55) may be used to connect topological qubits (49) in many ways to form a wide variety of quantum logic gates and circuits. **Fig. 28** is a schematic of a topological quantum register to illustrate a variety of connections that may be present in any combination in a topological quantum register or circuit. The top, arched path shows an example of a series of topological qubits (49) connected in series by controllable magnetic connection elements (55). The figure illustrates that qubits may be connected by controllable magnetic connection elements (55) to form diverging branches, converging branches, and loops. These individual configurations may be used together in any combination to form multiply branching or dendritic configurations, concatenated loops, and arrays. While the drawing illustrates a two-dimensional arrangement, three-dimensional arrays, branches, loops, and other three-dimensional configurations may be made using photolithography techniques.

## Claims

1. A controllable magnetic connection element (55) for connecting topological qubits, said connection element comprising:
a magnetic connector (251) sized and positioned to connect said topological qubits by a magnetic connection and
a magnet (53,51)
wherein:
said magnetic connector comprises a dilute magnetic semiconductor and
said magnet is configured to alter a paramagnetic/diamagnetic character of the magnetic connector to control the magnetic connection to allow or prevent the transmission of a spin current between the topological qubits.

2. The controllable magnetic connection element of claim 1, wherein said magnet is a permanent magnet (53) configured to be moved relative to said magnetic connector (251) and thereby alter the paramagnetic/diamagnetic character of the magnetic connector (251).

3. The controllable magnetic connection element of claim 1, wherein said magnet is an electrical coil (51) in apposition to said magnetic connector (251) configured to produce a magnetic field when activated and thereby alter the paramagnetic/diamagnetic character of the magnetic connector (251).

4. The controllable magnetic connection element of claim 1, wherein said dilute magnetic semiconductor comprises Tungsten-doped Vanadium Selenide or Tungsten-doped Vanadium Oxide.

5. The controllable magnetic connection element of claim 1, wherein said dilute magnetic semiconductor comprises Lithium-doped Graphene.

6. The controllable magnetic connection element of any of claims 1-5, wherein said topological qubits comprise a pnictogen trichalcogenide.

7. The controllable magnetic connection element of any of claims 1-6, further comprising said topological qubits, and wherein said topological qubits are connected by said magnetic connector such that said topological qubits may selectively be entangled or not entangled through said magnetic connector.

8. A topological quantum gate comprising the controllable magnetic connection element of claim 1.

9. A topological quantum register comprising the controllable magnetic connection element of claim 1.

10. A method for controlling entanglement between topological qubits, said method comprising:
controlling a magnetic field around a magnetic connection between said topological qubits to interrupt or allow transmission of spin polarised electrons between said topological qubits and thereby entangle or prevent entanglement between said topological qubits, wherein said magnetic connection comprises a dilute magnetic semiconductor.

11. The method of claim 10, wherein said controlling a magnetic field comprises moving a permanent magnet (53) relative to said magnetic connection.

12. The method of claim 10, wherein said controlling a magnetic field comprises energizing an electrical coil (51) that is positioned in apposition to said magnetic connection.

## Patentansprüche

1. Steuerbares magnetisches Verbindungselement (55) zum Verbinden von topologischen Qubits, wobei das Verbindungselement umfasst:
einen magnetischen Verbinder (251), der bemessen und positioniert ist, um die topologischen Qubits durch eine magnetische Verbindung zu verbinden, und
einen Magneten (53,51),
wobei:
der magnetische Verbinder einen verdünnten magnetischen Halbleiter umfasst und
der Magnet konfiguriert ist zum Verändern einer paramagnetischen/diamagnetischen Eigenschaft des magnetischen Verbinders, um die magnetische Verbindung so zu steuern, dass eine Übertragung eines Spinstroms zwischen den topologischen Qubits erlaubt oder verhindert wird.

2. Steuerbares magnetisches Verbindungselement nach Anspruch 1, wobei der Magnet ein Permanentmagnet (53) ist, der konfiguriert ist, um relativ zu dem magnetischen Verbinder (251) bewegt zu werden und um dadurch die paramagnetische/diamagnetische Eigenschaft des magnetischen Verbinders (251) zu verändern.

3. Steuerbares magnetisches Verbindungselement nach Anspruch 1, wobei der Magnet eine elektrische Spule (51) ist, die in einer Apposition zu dem magnetischen Verbinder (251) steht und die, wenn sie aktiviert wird, konfiguriert ist, um ein Magnetfeld zu erzeugen und um dadurch die paramagnetische/diamagnetische Eigenschaft des magnetischen Verbinders (251) zu verändern.

4. Steuerbares magnetisches Verbindungselement nach Anspruch 1, wobei der verdünnte magnetische Halbleiter ein Wolfram-dotiertes Vanadiumselenid oder ein Wolfram-dotiertes Vanadiumoxid umfasst.

5. Steuerbares magnetisches Verbindungselement nach Anspruch 1, wobei der verdünnte magnetische Halbleiter ein Lithium-dotiertes Graphen umfasst.

6. Steuerbares magnetisches Verbindungselement nach einem der Ansprüche 1 bis 5, wobei die topologischen Qubits ein Pnictogentrichalkogenid umfassen.

7. Steuerbares magnetisches Verbindungselement nach einem der Ansprüche 1 bis 6, das ferner die topologischen Qubits umfasst, und wobei die topologischen Qubits durch den magnetischen Verbinder derart verbunden sind, dass die topologischen Qubits durch den magnetischen Verbinder selektiv verschränkt oder nicht verschränkt werden können.

8. Topologisches Quanten-Gate, welches das steuerbare magnetische Verbindungselement nach Anspruch 1 umfasst.

9. Topologisches Quantenregister, welches das steuerbare magnetische Verbindungselement nach Anspruch 1 umfasst.

10. Verfahren zum Steuern einer Verschränkung zwischen topologischen Qubits, wobei das Verfahren umfasst:
Steuern eines Magnetfelds um eine magnetische Verbindung zwischen den topologischen Qubits herum, um eine Übertragung von spinpolarisierten Elektronen zwischen den topologischen Qubits zu unterbrechen oder zu erlauben und um dadurch topologische Qubits zu verschränken oder Verschränkungen zwischen den topologische Qubits zu verhindern, wobei die magnetische Verbindung einen verdünnten magnetischen Halbleiter umfasst.

11. Verfahren nach Anspruch 10, wobei das Steuern eines Magnetfelds ein Bewegen eines Permanentmagneten (53) relativ zu der magnetischen Verbindung umfasst.

12. Verfahren nach Anspruch 10, wobei das Steuern eines Magnetfelds ein Versorgen einer elektrischen Spule (51), die in einer Apposition zur magnetischen Verbindung positioniert ist, mit Energie umfasst.

## Revendications

1. Élément de connexion magnétique commandable (55) destiné à connecter des qubits topologiques, ledit élément de connexion comprenant :
un connecteur magnétique (251) dimensionné et positionné pour connecter lesdits qubits topologiques par le biais d'une connexion magnétique, et
un aimant (53, 51),
dans lequel :
ledit connecteur magnétique comprend un semi-conducteur magnétique dilué, et
ledit aimant est configuré pour modifier un caractère paramagnétique/diamagnétique du connecteur magnétique pour commander la connexion magnétique pour permettre ou empêcher la transmission d'un courant de spin entre les qubits topologiques.

2. Élément de connexion magnétique commandable de la revendication 1, dans lequel ledit aimant est un aimant permanent (53) configuré pour être déplacé relativement audit connecteur magnétique (251) et ainsi modifier le caractère paramagnétique/diamagnétique du connecteur magnétique (251).

3. Élément de connexion magnétique commandable de la revendication 1, dans lequel ledit aimant est une bobine électrique (51), en apposition audit connecteur magnétique (251), configurée pour produire un champ magnétique lorsqu'elle est activée, et ainsi modifier le caractère paramagnétique/diamagnétique du connecteur magnétique (251).

4. Élément de connexion magnétique commandable de la revendication 1, dans lequel ledit semi-conducteur magnétique dilué comprend du séléniure de vanadium dopé au tungstène ou de l'oxyde de vanadium dopé au tungstène.

5. Élément de connexion magnétique commandable de la revendication 1, dans lequel ledit semi-conducteur magnétique dilué comprend du graphène dopé au lithium.

6. Élément de connexion magnétique commandable de quelconques des revendications 1 à 5, dans lequel lesdits qubits topologiques comprennent un trichalcogénure de pnictogène.

7. Élément de connexion magnétique commandable de quelconques des revendications 1 à 6, comprenant en outre lesdits qubits topologiques, et dans lequel lesdits qubits topologiques sont connectés par ledit connecteur magnétique de manière telle que lesdits qubits topologiques peuvent sélectivement être intriqués ou non intriqués par le biais dudit connecteur magnétique.

8. Porte quantique topologique, comprenant l'élément de connexion magnétique commandable de la revendication 1.

9. Registre quantique topologique, comprenant l'élément de connexion magnétique commandable de la revendication 1.

10. Procédé pour commander l'intrication entre des qubits topologiques, ledit procédé comprenant :
la commande d'un champ magnétique autour d'une connexion magnétique entre lesdits qubits topologiques pour interrompre ou permettre une transmission d'électrons polarisés de spin entre lesdits qubits topologiques et ainsi intriquer ou empêcher l'intrication entre lesdits qubits topologiques, dans lequel ladite connexion magnétique comprend un semi-conducteur magnétique dilué.

11. Procédé de la revendication 10, dans lequel ladite commande d'un champ magnétique comprend le déplacement d'un aimant permanent (53) relativement à ladite connexion magnétique.

12. Procédé de la revendication 10, dans lequel ladite commande d'un champ magnétique comprend la mise sous tension d'une bobine électrique (51) qui est positionnée en apposition à ladite connexion magnétique.
